**Europäisches Patentamt**

**European Patent Office**

**Office européen des brevets**

(11) Publication number: **0 225 390**
**B1**

(12) **EUROPEAN PATENT SPECIFICATION**

(45) Date of publication of patent specification: **30.01.91**

(21) Application number: **86902026.3**

(22) Date of filing: **27.03.86**

(86) International application number:
**PCT/JP86/00144**

(87) International publication number:
**WO 86/07459 18.12.86 Gazette 86/27**

(51) Int. Cl.⁵: **G 01 R 33/38**

(54) **COIL FOR NUCLEAR MAGNETIC RESONANCE IMAGING DIAGNOSTIC APPARATUS.**

(30) Priority: **04.06.85 JP 119790/85**
**06.06.85 JP 121516/85**

(43) Date of publication of application:
**16.06.87 Bulletin 87/25**

(45) Publication of the grant of the patent:
**30.01.91 Bulletin 91/05**

(84) Designated Contracting States:
**DE GB NL**

(56) References cited:
**EP-A- 11 335**
**EP-A- 123 075**
**EP-A- 138 269**
**EP-A- 142 760**
**EP-A- 152 588**

**Patents Abstracts of Japan, vol. 9, no.86(P-349)(1809), 16. April 1985 & JP-A-59216045**

(73) Proprietor: **MITSUBISHI DENKI KABUSHIKI KAISHA**
**2-3, Marunouchi 2-chome Chiyoda-ku**
**Tokyo 100 (JP)**

(72) Inventor: **KAZUKI, Moritsu; Mitsubishi Denki Kabushiki Kaisha**
**Ako Seisakusho, 651, Tenwa, Ako-shi**
**Hyogo-ken, 678-02 (JP)**

(74) Representative: **Lawson, David Glynne et al**
**MARKS & CLERK 57-60 Lincoln's Inn Fields**
**London WC2A 3LS (GB)**

## Description

The present invention relates to a coil used for a nuclear magnetic resonance (NMR) imaging diagnostic apparatus, and more particularly to gradient magnetic field coils used for obtaining the position information in a nuclear magnetic resonance imaging diagnostic apparatus.

Background Art

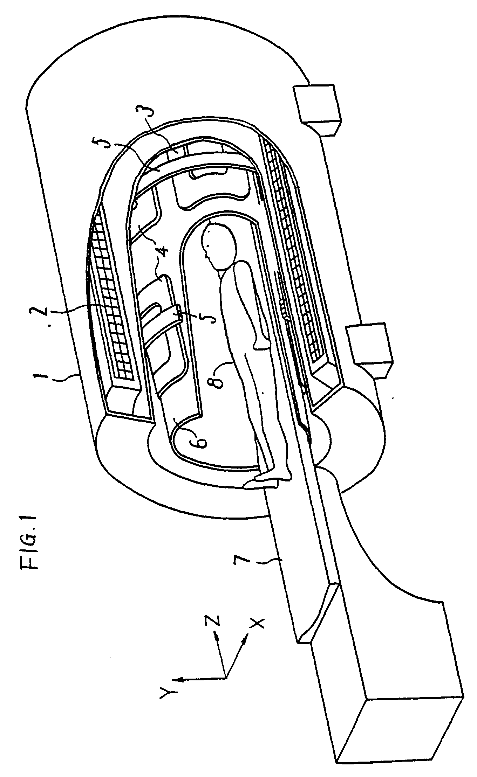

Fig. 1 shows a magnetic portion at the conventional superconductive nuclear magnetic resonance imaging diagnostic apparatus, comprising a superconductive main coil 2 contained in a cryostat 1 gradient magnetic field coils 3, 4 and 5 disposed inside the main coil 2, a bobbin 6, and a bed unit 7, so that an examinee is positioned within the bobbin 6. The gradient magnetic field coils comprising two pairs of X-direction gradient magnetic field coils 3, 3 . . . , each being a saddle-like shape and disposed transversely, two pairs of Y-direction gradient magnetic field coils 4, 4 . . . , each being a saddle-like shape and disposed vertically, and a pair of z-direction solenoid-type gradient magnetic field coils 5, 5 disposed longitudinally, are mounted on the bobbin 6 formed of a non-conductive material.

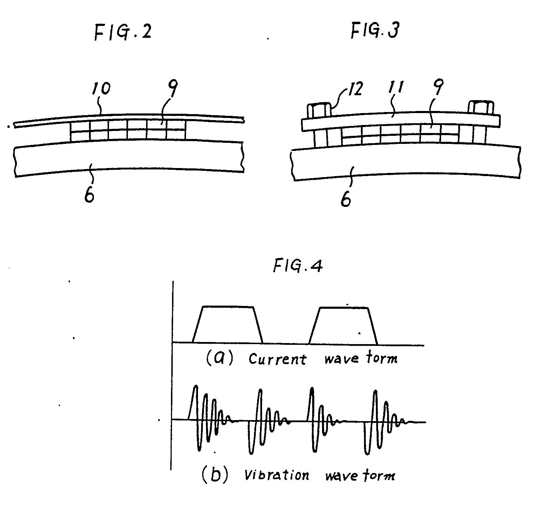

The gradient magnetic field coils 3, 4, 5 are mounted on the bobbin 6 in such a manner that the windings 9, 9 . . . of each gradient magnetic field coil 3, 4 or 5, as shown in Fig. 2, are secured to the bobbin 6 by a band 10, such as a glass fiber tape, or the windings 9, 9 . . . , as shown in Fig. 3, are press-contacted by bolts 12, 12 . . . through a pressure plate 11.

In the above-mentioned nuclear magnetic resonance imaging diagnostic apparatus, the gradient magnetic coils 3, 4 and 5 are excited in the intense DC magnetic field generated by the main coil 2, at which time a current flowing in the gradient magnetic field coils 3, 4 and 5, as shown in Fig. 4-(a), is of pulse-like wave form, so that the gradient magnetic field coils 3, 4 and 5 each generates an electromagnetic mechanical force, thereby vibrating as the current varies as shown in Fig. 4-(b).

The electromagnetic mechanical force generated in the gradient magnetic field coils 3, 4 and 5 is about similar in wave form to the current shown in Fig. 4-(a). Hence, the frequency component in the mechanical force is distributed in a wide frequency domain of DC to kHz, vibrations and noises caused thereby having the similar frequency component.

The conventional gradient magnetic field coil, whose windings are fixed directly to the bobbin, transmits vibrations thereof to the bobbin directly. As a result, a problem has occurred in that noises emitted together with the vibrations from the bobbin cause pain to the examinee positioned inside the bobbin.

EP—A1—0152588 Date of priority: 20.02.84, published on 28.08.85, state of the art pursuant to Article 54(3) EPC, discloses NMR apparatus in which gradient coils are united by support elements to form a "basket" which in turn is mounted on a tubular support body by rubber support elements, the basket being made of vibration-damping material. This construction is intended to damp noise.

EP—A1—0123075 describes NMR apparatus in which gradient coils are carried by a support pipe which is suspended by cables, which may have vibration damping means associated with them, to reduce noise.

EP—A2—0138269 discloses a gradient coil support with a noise-insulating sleeve mounted inside it by means of resilient rings, the space between the support and inner sleeve being evacuated to provide noise insulation.

JP 59—216045 describes gradient coils with interposed elastic packings, the coil assembly being potted in an elastic adhesive or filler, to reduce noise.

An object of the present invention is to provide a coil used for a nuclear magnetic resonance imaging diagnostic apparatus which reduces vibrations and noises.

According to the invention, there is provided a coil for a nuclear magnetic resonance imaging diagnostic apparatus provided with a main field coil and with gradient field coils within the main field coil, the gradient field coils being wound around and mounted on a bobbin, and vibration-proofing means, between the gradient field coils and the bobbin, characterised in that the gradient field coil winding is mounted against the bobbin with a vibration-damping elastic body sandwiched between the winding and the bobbin, and a mass body of non-magnetic material for reducing the characteristic vibration frequency is mounted on the opposite side of the winding, the winding being sandwiched between the mass body and the elastic body.

In this invention, the high frequency component sensitive to audibility among the wide frequency component of the generated noises is attenuated, thereby attenuating the high frequency component among vibrations transmitted from the coil to the bobbin through the vibration-proofing material, such as vibration-proofing rubber. In this case, when the characteristic frequency depending on the mass of coil and on the spring constant of vibration-proofing material is represented by $f_n$, the attenuated frequency component is $2 \times f_n$ or more. By adding a mass body of non-magnetic material, such as stainless steel to the gradient magnetic field coils, the mass of the coil is increased and the characteristic frequency of coil is lowered to expand the frequency domain having the damping effect.

Brief Description of the Drawings

Fig. 1 is a partially cutway perspective view of the principal portion of the above mentioned conventional nuclear magnetic resonance imaging diagnostic apparatus,

Figs. 2 and 3 are partially sectional views of construction of holding the above mentioned conventional gradient magnetic field coils on a bobbin,

Fig. 4 is a wave form chart of a current flowing in these gradient magnetic field coils and vibrations thereof,

Fig. 5 is a partially sectional view of an embodiment of a coil used for a nuclear-magnetic resonance imaging diagnostic apparatus according to a first embodiment of the invention, and

Fig. 6 is a partially sectional view of another embodiment of the invention.

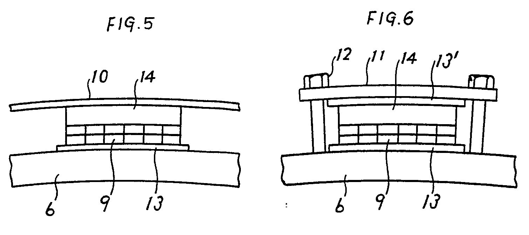

Fig. 5 shows the first embodiment of the invention in which windings 9, 9 . . . of gradient magnetic field coils are secured to a bobbin 6 by a band 10 with vibration-proofing rubber 13 interposed therebetween. The windings 9, 9 . . . are sandwiched between the vibration-proofing rubber 13 and a mass body 14 of non-magnetic material, such as stainless steel, and secured to the bobbin 6 by band 10.

Fig. 6 shows the other embodiment of the invention, in which the windings 9 are secured between the bobbin 6 and a pressure plate 11 with vibration-proofing rubber 13 and 13′ respectively interposed between the windings 9 and the bobbin 6 and between the mass body 14 and the pressure plate 11, and fixed to the bobbin 6 by bolts 12 through the pressure plate 11.

In the above construction, the gradient magnetic field coils whose windings 9 are supported on the bobbin 6 in a vibration-proofed condition are excited and, when generating an electromagnetic mechanical force, they vibrate in the same way as the conventional, but the vibrations transmitted to the bobbin 6 are attenuated of the high frequency component and vibrations in the bobbin 6 are reduced, thereby enabling a remarkable reduction of noises emitted from the bobbin 6.

The present invention is applicable as suppression means for vibrations and noises in the inclined magnetic field coils used for the nuclear magnetic resonance imaging diagnostic apparatus.

## Claims

1. A coil for a nuclear magnetic resonance imaging diagnostic apparatus provided with a main field coil (2) and with gradient field coils (3, 4, 5) within the main field coil (2), the gradient field coils being wound around and mounted on a bobbin (6), and vibration-proofing means (13), between the gradient field coils and the bobbin, characterised in that the gradient field coil winding (9) is mounted against the bobbin (6) with a vibration-damping elastic body (13) sandwiched between the winding (9) and the bobbin (6) and a mass body (14) of non-magnetic material for reducing the characteristic vibration frequency is mounted on the opposite side of the winding (9), the winding being sandwiched between the mass body (14) and the elastic body (13).

2. A coil as claimed in claim 1 in which the sandwich consisting of the mass body (14), winding (9) and elastic body (13) is held on the bobbin by clamping means (11) and a further elastic body (13′) is sandwiched between the mass body (14) and the clamping means (11).

3. A coil as claimed in claim 1 or 2 in which the mass body (14) is made of stainless steel.

## Patentansprüche

1. Spule für ein NMR-Tomographie-Diagnosegerät mit einer Hauptfeldspule (2) und Gradienten-Feldspulen (3, 4, 5) innerhalb der Hauptfeldspule (2), wobei die Gradienten-Feldspulen um einen Wickelkörper (6) gewickelt und darauf angeordnet sind, und einer Schwingungsdämpfungseinrichtung (13) zwischen den Gradienten-Feldspulen und dem Wickelkörper, dadurch gekennzeichnet, daß die Gradienten-Feldspulenwicklung (9) auf dem Wickelkörper (6) angeordnet ist, wobei ein schwingungsdämpfender elastischer Körper (13) zwischen der Wicklung (9) und dem Wickelkörper (6) eingeschlossen ist, und ein Massekörper (14) aus nichtnagnetischem Material zur Verringerung der charakteristischen Schwingungsfrequenz an der entgegengesetzten Seite der Wicklung (9) angeordnet ist, wobei die Wicklung zwischen dem Massekörper (14) und dem elastischen Körper (13) eingeschlossen ist.

2. Spule nach Anspruch 1, bei der die aus dem Massekörper (14), der Wicklung (9) und dem elastischen Körper (13) bestehende Sandwich-Anordnung durch eine Festlegeeinrichtung (11) auf dem Wickelkörper gehalten ist und zwischen dem Massekörper (14) und der Festlegeeinrichtung (11) ein weiterer elastischer Körper (13′) eingeschlossen ist.

3. Spule nach Anspruch 1 oder 2, bei der der Massekörper (14) aus rostfreiem Stahl besteht.

## Revendications

1. Un enroulement pour un appareil de diagnostic par imagerie à résonance magnétique nucléaire pourvu d'une bobine principale de champ (2) et de bobines de gradient de champ (3, 4, 5) dans la bobine de champ principale (2), les bobines de gradient de champ étant enroulées autour et montées sur un corps de bobine (6), et un moyen (13) d'amortissement de vibrations entre les bobines de gradient de champ et le corps de bobine, caractérisé en ce que l'enroulement des bobines de gradient de champ (9) est monté contre le corps de bobine (6) par un corps élastique d'amortissement de vibrations (13) monté en sandwich entre l'enroulement (9) et le corps de bobine (6) et un corps de masse (14) en un matériau non magnétique pour réduire la fréquence de vibration caractéristique est monté sur la côté opposé de l'enroulement (9), l'enroulement étant monté en sandwich entre le corps de masse (14) et le corps élastique (13).

2. Un enroulement selon la revendication 1, dans lequel le sandwich comprenant le corps de masse (14), l'enroulement (9) et le corps élastique (13) est maintenu sur le corps de bobine par un moyen de blocage (11) et un autre corps élastique (13′) est monté en sandwich entre le corps de masse (14) et le moyen de blocage (11).

3. Un enroulement selon la revendication 1 ou 2, dans lequel le corps de masse (14) est en acier inoxydable.

FIG.1

EP 0 225 390 B1

FIG.2

FIG.3

FIG.4

(a)   Current   wave form

(b)   Vibration   wave form

FIG.5

FIG.6